# EUROPÄISCHE PATENTSCHRIFT

(11) **EP 2 757 586 B1**
(45) Veröffentlichungstag und Bekanntmachung des Hinweises auf die Patenterteilung: **11.09.2019**
(21) Anmeldenummer: 13195357.2
(22) Anmeldetag: 02.12.2013
(51) Int. Cl.: H01L 25/07, H01L 25/18, H01R 13/24, H01R 12/70, H01R 13/05

(54) **Leistungshalbleitermodul und Verfahren zur Herstellung eines Leistungshalbleitermoduls**
Semiconductor power module and method for manufacturing the same
Module semi-conducteur de puissance et procédé de fabrication d'un module semi-conducteur de puissance

(30) Priorität: 16.01.2013 DE 102013200526
(43) Veröffentlichungstag der Anmeldung: 23.07.2014
(73) Patentinhaber: SEMIKRON Elektronik GmbH & Co. KG, 90431 Nürnberg (DE)
(72) Erfinder: Kulas, Hartmut, 91320 Ebermannstadt (DE)

(56) Entgegenhaltungen:
- EP-A1- 1 523 069
- EP-A1- 2 426 789
- DE-B3-102005 033 593
- DE-U1- 9 410 349
- JP-A- H1 032 031
- US-A- 5 772 449

## Beschreibung

Die Erfindung betrifft ein Leistungshalbleitermodul und ein Verfahren zur Herstellung eines Leistungshalbleitermoduls.

Bei aus dem Stand der Technik bekannten Leistungshalbleitermodulen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Aus der DE 10 2006 006 424 A1 ist eine Anordnung mit einem Leistungshalbleitermodul in Druckkontaktausführung und einem Kühlbauteil bekannt. Hierbei sind Lastanschlusselemente jeweils als Metallformkörper mit einem bandartigen Abschnitt und mit jeweils von diesem ausgehenden Kontaktfüßen ausgebildet.

Aus der EP 2 426 789 A1 ist eine Anschlusseinrichtung für ein Leistungshalbleitermodul, das ein Gehäuse für mindestens ein Schaltungssubstrat und einen Druckkörper zur Druckkontaktierung eines Anschlusselementes aufweist, das als Kontaktfeder mit einem ersten Kontaktteil und einem zweiten Kontaktteil und einem Federabschnitt zwischen dem ersten und dem zweiten Kontaktteil ausgebildet ist, bekannt.

Aus der EP 1 523 069 A1 ist eine Kontaktfeder, die zur Kontaktierung zwischen zumindest zwei Kontaktstellen, zwischen diesen Kontaktstellen zusammen mit einer die Kontaktfeder aufnehmenden Trägerplatte angeordnet ist, wobei die Kontaktfeder jeweils in Richtung einer Kontaktstelle zumindest einen Wölbungsbereich aufweist und im Bereich einer Seite unbewegbar mit der Trägerplatte verbindbar ist, bekannt.

Aus der DE 10 2005 033 593 B3 ist eine Kontaktfeder, die in Richtung jeweils einer Kontaktfläche Lamellen aufweist, wobei die Lamellen mit Kontaktstellen an den Kontaktflächen zur Anlage bringbar sind, bekannt.

Technikübliche Leistungshalbleitermodule weisen zur Führung von Lastströmen Laststromführungselemente auf, mit Hilfe derer das Substrat elektrisch leitend mit den Laststromanschlüssen der Leistungshalbleitermodule verbunden ist. Die Laststromanschlüsse können dabei integraler Bestandteil der Laststromführungselemente sein und z.B. in Form eines Endbereich des Laststromführungselements vorliegen. Die Lastströme weisen dabei in der Regel, im Gegensatz zu Hilfsströmen, welche z.B. zur Ansteuerung der Leistungshalbleiterschalter, dienen eine hohe Stromstärke auf.

Mechanische äußere Einflüsse, welche auf die Leistungshalbleitermodule von außen einwirken, wie z.B. mechanische Schwingungen, werden dabei über die Laststromführungselemente auf das Substrat übertragen und können z.B. zu einer Beschädigung des Substrats oder falls das Laststromführungselement mit dem Substrat mittels einer stoffschlüssigen Verbindung verbunden ist, zum Versagen der stoffschlüssigen Verbindung führen und somit zum Ausfall der Leistungshalbleitermodule führen.

Es ist Aufgabe der Erfindung ein zuverlässiges Leistungshalbleitermodul zu schaffen, sowie ein Verfahren zur Herstellung eines diesbezüglichen Leistungshalbleitermoduls anzugeben.

Diese Aufgabe wird gelöst durch ein Leistungshalbleitermodul mit einem Substrat und auf dem Substrat angeordneten und mit dem Substrat verbundenen Leistungshalbleiterbauelementen, wobei das Leistungshalbleitermodul eine einstückig ausgebildete elektrisch leitende Verbindungsvorrichtung aufweist, wobei die Verbindungsvorrichtung einen flachen ersten und einen flachen zweiten Anschlussbereich und einen zwischen dem ersten und zweiten Anschlussbereich angeordneten elastischen Bereich aufweist, wobei der elastische Bereich streifenförmige erste und zweite Formelemente aufweist, die zueinander eine gegensinnige Abwinklung aufweisen und alternierend angeordnet sind, wobei der erste Anschlussbereich mit dem Substrat verbunden ist, wobei die Verbindungsvorrichtung das Substrat elektrisch leitend mit einem elektrisch leitenden Laststromführungselement verbindet, wobei der zweite Anschlussbereich mit dem Laststromführungselement verbunden ist.

Weiterhin wird diese Aufgabe gelöst durch ein Verfahren zur Herstellung eines Leistungshalbleitermoduls mit folgenden Verfahrensschritten:
a) Bereitstellen eines Substrats und eines Metallblechelements, wobei das Metallblechelement einen flachen ersten und einen flachen zweiten Anschlussbereich aufweist und einen zwischen dem ersten und zweiten Anschlussbereich angeordneten Verbindungsbereich aufweist,
b) Stoffschlüssiges Verbinden des ersten Anschlussbereichs mit dem Substrat, wobei das Metallblechelement parallel zum Substrat verläuft,
c) Abwickeln des nicht mit dem Substrat verbunden Teils des Metallblechelements weg vom Substrat,
d) Einschneiden des Metallblechelements im Verbindungsbereich, so dass alternierend angeordnete streifenförmige erste und zweite Formelemente ausgebildet werden und gegensinniges Abwinkeln der ersten und zweiten Formelemente,
e) Verbinden eines elektrisch leitenden Laststromführungselements mit dem zweiten Anschlussbereich der Verbindungsvorrichtung.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen der Leistungshalbleitermodule und umgekehrt.

Es erweist sich als vorteilhaft, dass die Verbindungsvorrichtung das Substrat elektrisch leitend mit einem elektrisch leitenden Laststromführungselement verbindet, wobei der zweite Anschlussbereich mit dem Laststromführungselement verbunden ist, Hierdurch wird eine zuverlässige elektrische Verbindung des Substrats mit dem Laststromführungselement erzielt.

Weiterhin erweist es sich als vorteilhaft, wenn der stromführende Leitungsquerschnitt des ersten Anschlussbereichs und der stromführende Leitungsquerschnitt des zweiten Anschlussbereichs in Bezug auf den stromführenden Leitungsquerschnitt des elastischen Bereichs um maximal ±20% vom stromführenden Leitungsquerschnitt des elastischen Bereichs abweichen, da dann die Stromtragefähigkeit der Verbindungseinrichtung durch den elastischen Bereich der Verbindungseinrichtung kaum beeinträchtigt bzw. reduziert wird.

Ferner erweist es sich als vorteilhaft, wenn der erste Anschlussbereich einen mit dem Substrat verbundenen Abschnitt aufweist, der parallel zum Substrat verläuft, da dann der erste Anschlussbereich besonders zuverlässig mit dem Substrat verbunden werden kann.

Weiterhin erweist es sich als vorteilhaft, wenn zumindest ein Teil des zweiten Anschlussbereichs weg vom Substrat verläuft, da dann das Laststromführungselement entfernt vom Substrat angeordnet sein kann.

Ferner erweist es sich als vorteilhaft, wenn die Verbindung zwischen den Leistungshalbleiterbauelementen und dem Substrat, und/oder zwischen dem ersten Anschlussbereich der Verbindungsvorrichtung und dem Substrat, jeweilig als stoffschlüssige oder kraftschlüssige Verbindung realisiert ist. Hierdurch wird eine besonders zuverlässige Verbindung der jeweilig zu verbindenden Elemente erzielt.

Weiterhin erweist es sich als vorteilhaft, wenn das Substrat an seiner den Leistungshalbleiterbauelementen abgewandten Seite mit einem Metallformkörper verbunden ist, da hierdurch einer gute Kühlung der Leistungshalbleiterbauelemente ermöglicht wird.

Weiterhin erweist es sich als vorteilhaft, wenn der Metallformkörper als Metallplatte, welche zum thermischen Anbinden des Substrats an einen Kühlkörper dient, oder als Kühlkörper ausgebildet ist, da durch diese Maßnahme einer gute Kühlung der Leistungshalbleiterbauelemente ermöglicht wird.

Ferner erweist es sich als vorteilhaft, wenn das Einschneiden des Metallblechelements im Verbindungsbereich so erfolgt, dass alternierend abgeordnete streifenförmige erste und zweite Formelemente ausgebildet werden und das gegensinnige Abwinkeln der ersten und zweiten Formelemente, mittels eines kombinierten Schneidbiegewerkzeugs, in einem gemeinsamen Arbeitsschritt erfolgen. Hierdurch wird eine besonders rationelle Herstellung des Leistungshalbleitermoduls ermöglicht.

Ferner erweist es sich als vorteilhaft, wenn das stoffschlüssige Verbinden des ersten Anschlussbereichs mit dem Substrat in einem gemeinsamen Arbeitsschritt mit einem stoffschlüssigen Verbinden von Leistungshalbleiterbauelementen mit dem Substrat und/oder in einem gemeinsamen Arbeitsschritt mit einem stoffschlüssigen Verbinden der den Leistungshalbleiterbauelementen abgewandten Seite des Substrats mit einem Metallformkörper durchgeführt wird, wobei die jeweilige stoffschlüssige Verbindung in Form einer Sinterverbindung vorliegt. Hierdurch wird eine besonders rationelle Herstellung des Leistungshalbleitermoduls ermöglicht.

Weiterhin erweist es sich als vorteilhaft, dass ein Verbinden eines elektrisch leitenden Laststromführungselements mit dem zweiten Anschlussbereich der Verbindungsvorrichtung erfolgt. Hierdurch wird eine zuverlässige elektrische Verbindung des Substrats mit dem Laststromführungselement erzielt.

Weiterhin erweist es sich als vorteilhaft, wenn ein Anordnen einer die Leistungshalbleiterbauelemente und das Substrat abdeckenden Abdeckung erfolgt, wobei die Abdeckung Ausnehmungen ausweist, durch die die Verbindungsvorrichtung verläuft. Durch die Abdeckung werden die Leistungshalbleiterbauelemente geschützt.

Weiterhin sei angemerkt, das alternativ Verfahrensschritt d) auch vor Verfahrensschritt c) durchgeführt werden kann.

Ein Ausführungsbeispiel der Erfindung ist in den Figuren dargestellt und wird im Folgenden näher erläutert. Dabei zeigen:
- FIG 1: eine schematisierte perspektivische Darstellung eines erfindungsgemäßen Leistungshalbleitermoduls,
- FIG 2: eine schematisierte Schnittdarstellung eines erfindungsgemäßen Leistungshalbleitermoduls,
- FIG 3: eine schematisierte Schnittdarstellung eines noch nicht fertig gestellten erfindungsgemäßen Leistungshalbleitermoduls bei der Herstellung des Leistungshalbleitermoduls,
- FIG 4: eine schematisierte perspektivische Darstellung eines Metallblechelements im abgewickelten Zustand,
- FIG 5: eine schematisierte perspektivische Darstellung eines kombinierten Schneidbiegewerkzeugs zum Einschneiden des Metallblechelements und Abwinkeln beim Einschneiden entstehender erster und zweiter Formelemente,
- FIG 6: eine schematisierte perspektivische Darstellung einer Verbindungsvorrichtung und
- FIG 7: ein schematisierte perspektivische Darstellung eines erfindungsgemäßen Leistungshalbleitermoduls mit einer Abdeckung.

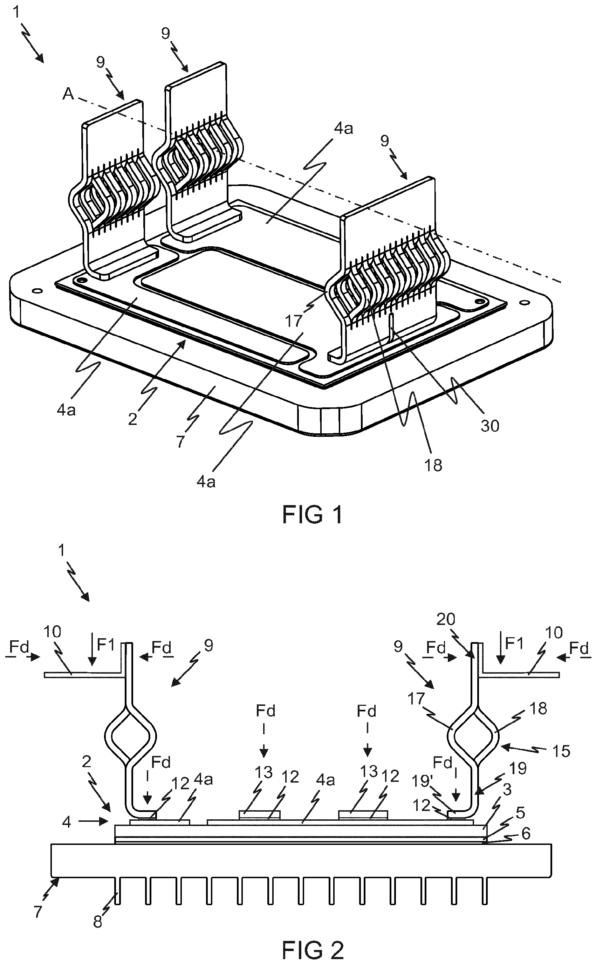

In FIG 1 ist eine schematisierte perspektivische Darstellung eines erfindungsgemäßen Leistungshalbleitermoduls 1 dargestellt. In FIG 2 ist eine schematisierte Schnittdarstellung des erfindungsgemäßen Leistungshalbleitermoduls 1 dargestellt, wobei der Schnitt entlang der in FIG 1 dargestellten Linie A verläuft. Das Leistungshalbleitermodul 1 weist ein Substrat 2, das beim Ausführungsbeispiel in Form eines DCB-Substrats vorliegt und auf dem Substrat 2 angeordnete und mit dem Substrat 2 verbundene Leistungshalbleiterbauelemente 13 auf. Aus Gründen der Übersichtlichkeit sind die Leistungshalbleiterbauelemente 13 in FIG 1 nicht dargestellt. Das jeweilige Leistungshalbleiterbauelement liegt vorzugsweise in Form eines Leistungshalbleiterschalters oder einer Diode vor. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor. Im Rahmen des Ausführungsbeispiels weisen die Leistungshalbleiterschalter 13 an Ihrer dem Substrat 2 zugewandten Seite jeweilig einen ersten Leistungshalbleiterlaststromanschluss und an Ihrer dem Substrat 2 abgewandten Seite jeweilig einen zweiten Leistungshalbleiterlaststromanschluss auf.

Das Substrat 2 weist einen Isolierstoffkörper 3 und eine auf einer ersten Seite des Isolierstoffkörpers 3 angeordnete und mit dem Isolierstoffkörper 3 verbundene elektrisch leitende strukturierte erste Leitungsschicht 4 auf, die im Rahmen des Ausführungsbeispiels Leiterbahnen 4a ausbildet. Vorzugsweise weist das Substrat 2 eine elektrisch leitende, vorzugsweise unstrukturierte zweite Leitungsschicht 5 auf, wobei der Isolierstoffkörper 4 zwischen der strukturierten ersten Leitungsschicht 4 und der zweiten Leitungsschicht 5 angeordnet ist. Die strukturierte erste Leitungsschicht 4 des Substrats 2 kann z.B. aus Kupfer bestehen. Das Substrat 2 kann z.B., wie beim Ausführungsbeispiel, in Form eines Direct Copper Bonded Substrats (DCB-Substrat) oder in Form eines Insulated Metal Substrats (IMS) vorliegen. Im Falle eines DCB-Substrats kann der Isolierstoffkörper 3 z.B. aus einer Keramik bestehen und die zweite Leitungsschicht 5 des Substrats z.B. aus Kupfer bestehen. Im Falle eines Insulated Metal Substrats kann der Isolierstoffkörper 3 z.B. aus einer Schicht aus Polyimid oder Epoxy bestehen und die zweite Leitungsschicht 5 des Substrats 2 aus einem Metallformkörper bestehen. Der Metallformkörper kann z.B. aus Aluminium oder einer Aluminiumlegierung bestehen.

Es sei an dieser Stelle angemerkt, dass die erste und/oder die zweite Leitungsschicht des Substrats 2 auch aus mehreren übereinanderliegende Schichten bestehen kann. So kann die erste und/oder die zweite Leitungsschicht z.B. eine Kupferschicht aufweisen, die eine einzelne oder mehrere übereinanderliegende Beschichtungen, z.B. aus einem Edelmetall (z.B. Silber) oder aus einer Edelmetallverbindung aufweist, welche z.B. als Haftvermittlungsschichten und/oder Schutzschichten dienen können. Die Leiterbahnen 4a des Substrats 2 können somit jeweilig auch mehrere Schichten aufweisen.

Es sei weiterhin angemerkt, dass im einfachsten Falle das Substrat 2 auch nur eine einzelne Leiterbahn und/oder ein einzelnes Leistungshalbleiterbauelement aufweisen kann.

Weiterhin weist das Leistungshalbleitermodul 1 einstückig ausgebildete elektrisch leitende Verbindungsvorrichtungen 9 auf, die das Substrat 2, genauer ausgedrückt die erste Leitungsschicht 4 des Substrat 2, elektrisch leitend mit jeweilig zugeordneten elektrisch leitenden Laststromführungselementen 10 verbinden. Der Übersichtlichkeit halber sind die Laststromführungselemente 10 nur in FIG 2 dargestellt. Im Allgemeinen ist mit Hilfe der Laststromführungselemente 10 das Substrat 2 elektrisch leitend mit Laststromanschlüssen der Leistungshalbleitermoduls 1 verbunden. Die Laststromanschlüsse können dabei integraler Bestandteil der Laststromführungselemente sein und z.B. in Form eines Endbereich des Laststromführungselements vorliegen. Die Lastströme weisen dabei in der Regel, im Gegensatz zu Hilfsströmen, welche z.B. zur Ansteuerung der Leistungshalbleiterschalter dienen, eine hohe Stromstärke auf.

Es sei angemerkt, dass im einfachsten Falle das Leistungshalbleitermodul 1 auch nur eine einzelne elektrisch leitende erfindungsgemäße Verbindungsvorrichtung aufweisen kann.

Die Verbindungsvorrichtungen 9 weisen einen flachen ersten Anschlussbereich 19 und einen flachen zweiten Anschlussbereich 20 und einen zwischen dem ersten und zweiten Anschlussbereich 19 und 20 angeordneten elastischen Bereich 15 auf, wobei der elastische Bereich 15 streifenförmige erste Formelemente 17 und streifenförmige zweite Formelemente 18 aufweist, die zueinander eine gegensinnige Abwinklung aufweisen. Die ersten und zweiten Formelemente 17 und 18 sind alternierend angeordnet, d.h. auf ein erstes Formelement ist unmittelbar benachbart ein zweites Formelement angeordnet und unmittelbar benachbart zu dem zweiten Formelement ist ein weiteres erstes Formelement angeordnet, auf das wiederum ein benachbart angeordnetes weiteres zweites Formelement folgt usw.. Die ersten und zweiten Formelemente 17 und 18 sind vorzugsweise jeweils in einer parallel zum Substrat 2 verlaufenden Reihe angeordnet.

Der erste Anschlussbereich 19 ist mit dem Substrat 2, genauer ausgedrückt mit der ersten Leitungsschicht 4 des Substrats 2 verbunden und der zweite Anschlussbereich 20 ist mit dem Laststromführungselement 10 verbunden.

Vorzugsweise ist der der stromführende Leitungsquerschnitt des ersten und des zweiten Anschlussbereichs 19 und 20 und des elastischen Bereichs 15 gleich groß.

Im Rahmen des Ausführungsbeispiels verläuft der zweite Anschlussbereich 20 senkrecht weg vom Substrat 2. Es sei dabei angemerkt, dass der zweite Anschlussbereich 20 auch einen, z.B. um 90° zum Rest des zweite Anschlussbereichs 20 abgewinkelten Endbereich aufweisen kann. Somit verläuft vorzugsweise zumindest ein Teil des zweiten Anschlussbereichs 20 senkrecht weg vom Substrat 2.

Die Verbindungsvorrichtungen 19 können z.B. aus Kupfer bestehen, wobei die Verbindungsvorrichtungen 19 mit einer einzelnen oder mehreren Beschichtungen versehen sein können.

Im Rahmen des Ausführungsbeispiels weist der erste Anschlussbereich 19 einen mit dem Substrat 2 verbundenen Abschnitt 19' auf, der parallel zum Substrat 2 verläuft, wobei der Abschnitt 19' mit dem Substrat 2, genauer ausgedrückt mit der ersten Leitungsschicht 4 des Substrats 2, verbunden ist.

Vorzugsweise ist die Verbindung zwischen den Leistungshalbleiterbauelementen 13 und dem Substrat 2, und/oder zwischen dem ersten Anschlussbereich 19 der jeweiligen Verbindungsvorrichtung 9 und dem Substrat 2, und/oder zwischen dem zweiten Anschlussbereich 20 der jeweiligen Verbindungsvorrichtung 9 und dem jeweiligen Laststromführungselement 10, jeweilig als stoffschlüssige oder kraftschlüssige Verbindung realisiert. Die jeweilige stoffschlüssige Verbindung kann z.B. in Form einer Schweiß-, Löt-, Klebe- oder Sinterverbindung vorliegen, wobei im Falle der Verbindung zwischen den Leistungshalbleiterbauelementen 13 und dem Substrat 2, diese vorzugsweise in Form einer Löt-, Klebe- oder Sinterverbindung vorliegt. Im Falle einer Klebeverbindung wird eine elektrisch leitfähiger Klebstoff verwendet.

Alternativ hierzu können, was in FIG 2 durch gestrichelte Pfeile angedeutet dargestellt ist, die jeweiligen Verbindungen auch als kraftschlüssige Verbindungen realisiert sein. Dabei übt eine einzelne oder mehrere in den Figuren nicht dargestellte Krafterzeugungseinrichtungen Verbindungskräfte Fd permanent auf die zu verbindenden jeweiligen Elemente aus. Es sei an dieser Stelle angemerkt, dass im Sinne der vorliegenden Erfindung eine Schraubverbindung als eine Form einer kraftschlüssigen Verbindung angesehen wird.

Beim Ausführungsbeispiel ist die Verbindung zwischen den Leistungshalbleiterbauelementen 13 und dem Substrat 2 und zwischen dem ersten Anschlussbereich 19 der jeweiligen Verbindungsvorrichtung 9 und dem Substrat 2 als Sinterverbindung realisiert, so dass zwischen den Leistungshalbleiterbauelementen 13 und dem Substrat 2, und zwischen dem ersten Anschlussbereich 19 der jeweiligen Verbindungsvorrichtung 9 und dem Substrat 2, jeweilig eine Sinterschicht 12 angeordnet ist. Weiterhin ist beim Ausführungsbeispiel die jeweilige Verbindung zwischen dem zweiten Anschlussbereich 20 der jeweiligen Verbindungsvorrichtung 9 und dem jeweiligen Laststromführungselement 10 als Schweißverbindung ausgebildet. Der Übersichtlichkeit ist die zwischen den Verbindungsvorrichtungen 9 und dem Substrat 2 jeweilig angeordnete Sinterschicht 12 in FIG 1 nicht dargestellt.

Mechanische äußere Einflüsse, welche auf das erfindungsgemäße Leistungshalbleitermodul 1 von außen einwirken, wie z.B. mechanische Schwingungen, werden bei der Erfindung nicht bzw. reduziert über die Laststromführungselemente auf das Substrat übertragen, da der elastische Bereich 15 der jeweiligen Verbindungsvorrichtungen 9 eine mechanische Entkopplung des Substrats 2 von den Laststromführungselementen 10 bewirkt. Eine Beschädigung des Substrats 2 oder ein Versagen der stoffschlüssigen Verbindungen, falls die Laststromführungselemente mit dem Substrat mittels stoffschlüssiger Verbindungen verbunden sind, kann somit zuverlässig vermieden werden. Da weiterhin vorzugsweise der stromführende Leitungsquerschnitt des ersten und des zweiten Anschlussbereichs und des elastischen Bereichs 15 ungefähr gleich groß sind, wird die Stromtragefähigkeit der Verbindungseinrichtung 9 durch den elastischen Bereich 15 der Verbindungseinrichtung 9 kaum beeinträchtigt bzw. reduziert. Die stromführenden Leitungsquerschnitte des ersten und des zweiten Anschlussbereichs 19 und 20 in Bezug auf den stromführenden Leitungsquerschnitt des elastischen Bereichs 15 können vorzugsweise um maximal ±20%, insbesondere um maximal ±15% vom stromführenden Leitungsquerschnitt des elastischen Bereichs 15 abweichen. Es sei dabei angemerkt, dass die Verbindungsvorrichtung 9 im Bereich des ersten und/oder des zweiten Anschlussbereichs, einen in Richtung des elastischen Bereichs 15 verlaufenden Spalt 30 aufweisen kann, so dass der stromführende Leitungsquerschnitt des elastischen Bereichs 15 auch größer sein kann als die stromführenden Leitungsquerschnitte des ersten und/oder des zweiten Anschlussbereichs.

Das Substrat 2 ist vorzugsweise an seiner den Leistungshalbleiterbauelementen 13 abgewandten Seite mit einem Metallformkörper 7 verbunden. Der Metallformkörper 7 kann z.B. als Metallplatte, welche zum thermischen Anbinden des Substrats an einen Kühlkörper dient, oder wie im Ausführungsbeispiel als Kühlkörper ausgebildet sein. Der Kühlkörper weist vorzugsweise Kühlfinnen oder Kühlnoppen 8 auf. Die Verbindung zwischen Substrat 2 und Metallformkörper 7 kann als stoffschlüssige oder kraftschlüssige Verbindung realisiert sein. Die stoffschlüssige Verbindung kann z.B. in Form einer Schweiß-, Löt-, Klebe- oder Sinterverbindung vorliegen, wobei die Verwendung einer Sinterverbindung besonders vorteilhaft ist, da diese eine hohe mechanische Festigkeit und eine hohe thermische Leitfähigkeit aufweist. Beim Ausführungsbeispiel ist die Verbindung zwischen dem Substrat 2 und dem Metallformkörper 7 als Sinterverbindung realisiert, so dass zwischen dem Substrat 2 und dem Metallformkörper 7 eine Sinterschicht 6 angeordnet ist.

Es sei an dieser Stelle angemerkt, dass im Sinne der Erfindung unter einem Kühlkörper ein fester Körper verstanden wird, der im Betrieb des Leistungshalbleitermoduls dazu dient von einem anderen festen Körper Wärme aufzunehmen und die aufgenommene Wärme oder einen überwiegenden Teil der aufgenommenen Wärme an ein flüssiges Medium und/oder an ein gasförmiges Medium, das einen Kontakt mit dem Kühlkörper aufweist, abzugeben. Gegebenenfalls kann ein kleiner Teil der vom Kühlkörper aufgenommenen Wärme an einen weiteren festen Körper abgegeben werden.

Es sei weiterhin angemerkt, dass die Leistungshalbleiterbauelemente an Ihrer dem Substrat abgewandten Seite, mittels z.B. Bonddrähten und/oder einem Folienverbund miteinander und mit den Leiterbahnen des Substrats, entsprechend der gewünschten elektrischen Schaltung, welche das Leistungshalbleitermodul 1 realisieren soll, elektrisch leitend miteinander verbunden sind. Der Übersichtlichkeit halber sind diese elektrischen Verbindungen in den Figuren nicht dargestellt.

Im Folgenden wird ein erfindungsgemäßes Verfahren zur Herstellung des Leistungshalbleitermoduls 1 beschrieben.

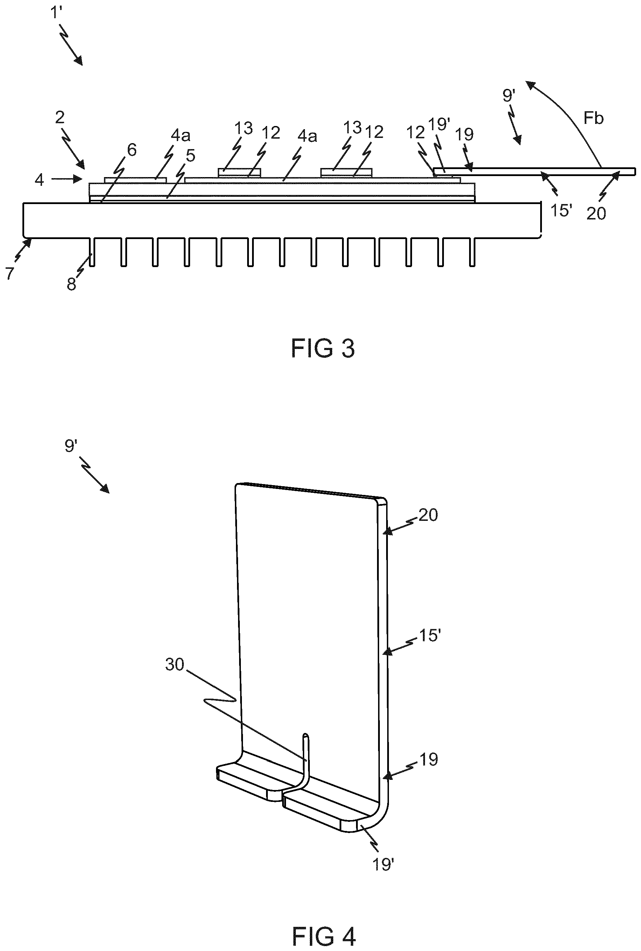

In FIG 3 ist eine schematisierte Schnittdarstellung eines noch nicht fertig gestellten erfindungsgemäßen Leistungshalbleitermoduls 1' bei der Herstellung des Leistungshalbleitermoduls 1 dargestellt. Es sei angemerkt, dass in den Figuren gleiche Elemente mit den gleichen Bezugszeichen versehen sind.

In einem ersten Verfahrensschritt erfolgt ein Bereitstellen des Substrats 2 und eines Metallblechelements 9', wobei das Metallblechelement 9' einen flachen ersten und einen flachen zweiten Anschlussbereich 19 und 20 aufweist und einen zwischen dem ersten und zweiten Anschlussbereich angeordneten Verbindungsbereich 15' aufweist.

Vorzugsweise erfolgt zusätzlich auch ein Bereitstellen der Leistungshalbleiterbauelemente 13 und/oder des Metallformkörpers 7.

Aus dem Metallblechelement 9' wird in den nachfolgenden Verfahrensschritten die Verbindungsvorrichtung 9 ausgebildet, wobei aus dem Verbindungsbereich 15' der elastische Bereich 15 ausgebildet wird.

In einem nachfolgenden Verfahrensschritt erfolgt ein stoffschlüssiges Verbinden des ersten Anschlussbereichs 19 mit dem Substrat 2, wobei das Metallblechelement 9' parallel zum Substrat 2 verläuft. Beim Ausführungsbeispiel wird dabei der Abschnitt 19' des ersten Anschlussbereichs 19 stoffschlüssig mit dem Substrat 2, genauer ausgedrückt, mit der ersten Leistungsschicht 4 des Substrats 2 verbunden. Vorzugsweise erfolgt zusätzlich auch ein stoffschlüssiges Verbinden der Leistungshalbleiterbauelemente 13 mit dem Substrat 2, genauer ausgedrückt mit der ersten Leistungsschicht 4 des Substrats 2, und/oder des Substrat 2, genauer ausgedrückt der zweiten Leistungsschicht 5 des Substrats 2, mit dem Metallformkörpers 7. Die jeweilige stoffschlüssige Verbindung kann z.B. in Form einer Schweiß-, Löt-, Klebe- oder Sinterverbindung vorliegen, wobei im Falle der Verbindung zwischen den Leistungshalbleiterbauelementen 13 und dem Substrat 2, diese vorzugsweise in Form einer Löt-, Klebe- oder Sinterverbindung vorliegt. Im Falle einer Klebeverbindung wird eine elektrisch leitfähiger Klebstoff verwendet.

Die Verwendung einer Sinterverbindung zur Verbindung der oben aufgeführten Elemente ist dabei besonders vorteilhaft, da eine Sinterverbindung eine hohe mechanische Festigkeit und eine hohe thermische Leitfähigkeit aufweist. Vorzugsweise erfolgt ein stoffschlüssiges Verbinden des ersten Anschlussbereichs 19 mit dem Substrat 2 in einem gemeinsamen Arbeitsschritt mit einem stoffschlüssigen Verbinden der Leistungshalbleiterbauelemente 13 mit dem Substrat 2 und/oder in einem gemeinsamen Arbeitsschritt mit einem stoffschlüssigen Verbinden der den Leistungshalbleiterbauelementen 13 abgewandten Seite des Substrats 2, d.h. beim Ausführungsbeispiel der zweiten Leitungsschicht 5 des Substrats 2, mit einem Metallformkörper 7, wobei die jeweilige stoffschlüssige Verbindung in Form einer Sinterverbindung vorliegt. Zur Realisierung der Sinterverbindungen wird vorzugsweise zwischen den zu verbindenden Elementen eine Sinterpaste angeordnet und anschließend in einem gemeinsamen Arbeitsschritt unter Druck- und Temperaturbeaufschlagung der Elemente die zu verbindenden Elemente miteinander verbunden. Solchermaßen können mehrere Elemente in einem gemeinsamen Arbeitsschritt miteinander mittels einer jeweiligen Sinterverbindung verbunden werden, was eine besonders rationelle Fertigung des erfindungsgemäßen Leistungshalbleitermoduls 1 ermöglicht. Wenn die Leistungshalbleiterbauelemente13 an Ihrer dem Substrat 2 abgewandten Seite mittels eines Folienverbunds miteinander und mit den Leiterbahnen des Substrats, entsprechend der gewünschten elektrischen Schaltung, welche das Leistungshalbleitermodul 1 realisieren soll, elektrisch leitend miteinander mittels einer Sinterverbindung verbunden werden sollen, können die dafür notwenigen Sinterverbindungen ebenfalls in dem oben genannten gemeinsamen Arbeitsschritt durchgeführt werden.

In einem weiteren Verfahrensschritt erfolgt ein Abwickeln des nicht mit dem Substrat 2 verbunden Teils des Metallblechelements 9' weg vom Substrat 2. Vorzugsweise erfolgt dabei ein Abwickeln des nicht mit dem Substrat 2 verbunden Teils des Metallblechelements 9' weg vom Substrat 2 in einem Wickel von 90°. In FIG 4 ist eine schematisierte perspektivische Darstellung des Metallblechelements 9' im abgewickelten Zustand dargestellt, wobei der Übersichtlichkeit halber die übrigen Elemente des Leistungshalbleitermoduls 1 nicht dargestellt sind, sondern nur das Metallblechelement 9' dargestellt ist.

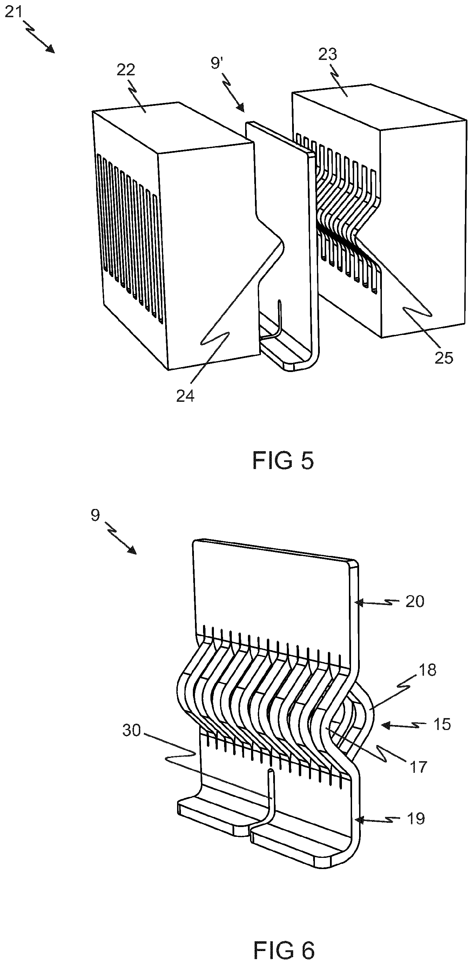

In einem weiteren Verfahrensschritt erfolgt ein Einschneiden des Metallblechelements 9' im Verbindungsbereich 15', so dass die alternierend angeordneten streifenförmigen ersten und zweiten Formelemente 17 und 18 ausgebildet werden und ein gegensinniges Abwinkeln der ersten und zweiten Formelemente 17 und 18. Vorzugsweise erfolgt das Einschneiden des Metallblechelements 9' im Verbindungsbereich 15', so dass alternierend abgeordnete streifenförmige erste und zweite Formelemente 17 und 18 ausgebildet werden und das gegensinnige Abwinkeln der ersten und zweiten Formelemente 17 und 18, im Rahmen des Ausführungsbeispiels mittels eines kombinierten Schneidbiegewerkzeugs 21, in einem gemeinsamen Arbeitsschritt. Das kombinierte Schneidbiegewerkzeugs 21 zum Einschneiden des Metallblechelements 9' und Abwinkeln beim Einschneiden entstehender erster und zweiter Formelemente 17 und 18 ist in FIG 5 in Form einer schematisierten perspektivischen Darstellung dargestellt. Das Schneidbiegewerkzeugs 21 weist ein erstes Werkzeugteil 22 mit hervorstehenden ersten Schneidbiegekanten 24 und ersten Öffnungen, und ein zweites Werkzeugteil 23 mit hervorstehenden zweiten Schneidbiegekanten 25 und zweiten Öffnungen auf, wobei die ersten Schneidbiegekanten 24 und die zweiten Schneidbiegekanten 25 lateral versetzt zu einander angeordnet sind, wobei das erste und das zweite Werkzeugteil 22 und 23 derart angeordnet sind, dass wenn das erste Werkzeugteil 22 auf das zweite Werkzeugteil 23 zu bewegt wird, die ersten Schneidbiegekanten 24 in die zweiten Öffnungen eingreifen und die zweiten Schneidbiegekanten 23 in die ersten Öffnungen eingreifen. Es sei angemerkt, dass bei diesem Verfahrensschritt das Einschneiden des Metallblechelements, so dass alternierend abgeordnete streifenförmige erste und zweite Formelemente ausgebildet werden und das gegensinnige Abwinkeln der ersten und zweiten Formelemente auch hintereinander in zwei separaten Arbeitsschritten ausgeführt werden kann.

Zur Herstellung der jeweiligen Verbindungsvorrichtung 9 wird das Metallblechelement 9' zwischen dem ersten und zweiten Werkzeugteil 22 und 23 angeordnet und dann das erste und zweite Werkzeugteil 22 und 23 aufeinander zu bewegt, so dass aus dem Verbindungsbereich 15' der elastische Bereich 15 mit den streifenförmigen ersten und zweiten Formelementen 17 und 18 entsteht und die in FIG 6 dargestellte Verbindungsvorrichtung 9 ausgebildet wird.

Gegebenenfalls kann das Metallblechelements 9' im Bereich des ersten und/oder des zweiten Anschlussbereichs, einen in Richtung des Verbindungsbereich 15' verlaufenden Spalt aufweisen, der bei der fertigen Verbindungsvorrichtung 9, den Spalt 30 ausbildet.

Es sei an dieser Stelle angemerkt, dass wenn die mechanische Stabilität der Metallblechelements 9' es erlaubt, der Verfahrensschritt des Abwickelns des nicht mit dem Substrat verbunden Teils des Metallblechelements weg vom Substrat auch vor dem Verfahrensschritt des Einschneidens des Metallblechelements im Verbindungsbereich, so dass alternierend abgeordnete streifenförmige erste und zweite Formelemente ausgebildet werden und des gegensinnigen Abwinkelns der ersten und zweiten Formelemente durchgeführt werden kann.

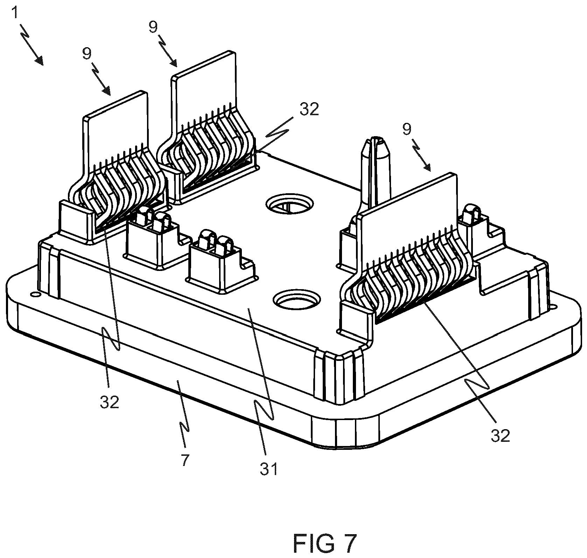

Vorzugsweise erfolgt in einem weiteren Verfahrensschritt, ein Anordnen einer die Leistungshalbleiterbauelemente 13 und das Substrat 2 abdeckenden Abdeckung 31, wobei die Abdeckung 31 Ausnehmungen 32 ausweist, durch die Verbindungsvorrichtungen 9 verlaufen. In FIG 7 ist eine schematisierte perspektivische Darstellung des Leistungshalbleitermoduls 1 mit der Abdeckung 31 dargestellt, wobei in FIG 1 und FIG 2 der Übersichtlichkeit halber die Abdeckung 31 nicht dargestellt ist.

In einem weiteren Verfahrensschritt erfolgt ein Verbinden von elektrisch leitenden Laststromführungselementen 10 mit dem zweiten Anschlussbereich der jeweilig zugeordneten Verbindungsvorrichtungen 9. Die jeweilige Verbindung zwischen den Laststromführungselementen 10 und den Verbindungsvorrichtungen 9 liegt dabei vorzugsweise in Form einer stoff- oder kraftschlüssigen Verbindung vor.

## Patentansprüche

1. Leistungshalbleitermodul mit einem Substrat (2) und auf dem Substrat (2) angeordneten und mit dem Substrat (2) verbundenen Leistungshalbleiterbauelementen (13), wobei das Leistungshalbleitermodul (1) eine einstückig ausgebildete elektrisch leitende Verbindungsvorrichtung (9) aufweist, wobei die Verbindungsvorrichtung (9) einen flachen ersten und einen flachen zweiten Anschlussbereich (19,20) und einen zwischen dem ersten und zweiten Anschlussbereich (19,20) angeordneten elastischen Bereich (15) aufweist, wobei der elastische Bereich (15) streifenförmige erste und zweite Formelemente (17,18) aufweist, die zueinander eine gegensinnige Abwinklung aufweisen und alternierend angeordnet sind, wobei der erste Anschlussbereich (19) mit dem Substrat (2) verbunden ist, wobei die Verbindungsvorrichtung (9) das Substrat (2) elektrisch leitend mit einem elektrisch leitenden Laststromführungselement (10) verbindet, wobei der zweite Anschlussbereich (20) mit dem Laststromführungselement (10) verbunden ist.

2. Leistungshalbleitermodul nach Anspruch 1, **dadurch gekennzeichnet, dass** der stromführende Leitungsquerschnitt des ersten Anschlussbereichs (19) und der stromführende Leitungsquerschnitt des zweiten Anschlussbereichs (20) in Bezug auf den stromführenden Leitungsquerschnitt des elastischen Bereichs (15) um maximal ±20% vom stromführenden Leitungsquerschnitt des elastischen Bereichs (15) abweichen.

3. Leistungshalbleitermodul nach einem der vorhergehenden Ansprüche, **dadurch gekennzeichnet, dass** der erste Anschlussbereich (19) einen mit dem Substrat (2) verbundenen Abschnitt (19') aufweist, der parallel zum Substrat (2) verläuft.

4. Leistungshalbleitermodul nach einem der vorhergehenden Ansprüche, **dadurch gekennzeichnet, dass** zumindest ein Teil des zweiten Anschlussbereichs (20) weg vom Substrat (2) verläuft.

5. Leistungshalbleitermodul nach einem der vorhergehenden Ansprüche, **dadurch gekennzeichnet, dass** die Verbindung zwischen den Leistungshalbleiterbauelementen (13) und dem Substrat (2), und/oder zwischen dem ersten Anschlussbereich (19) der Verbindungsvorrichtung (9) und dem Substrat (2), jeweilig als stoffschlüssige oder kraftschlüssige Verbindung realisiert ist.

6. Leistungshalbleitermodul nach einem der vorhergehenden Ansprüche, **dadurch gekennzeichnet, dass** das Substrat (2) an seiner den Leistungshalbleiterbauelementen (13) abgewandten Seite mit einem Metallformkörper (7) verbunden ist.

7. Leistungshalbleitermodul nach Anspruch 6, **dadurch gekennzeichnet, dass** der Metallformkörper (7) als Metallplatte, welche zum thermischen Anbinden des Substrats (2) an einen Kühlkörper dient, oder als Kühlkörper ausgebildet ist.

8. Leistungshalbleitermodul nach Anspruch 6 oder 7, **dadurch gekennzeichnet, dass** die Verbindung zwischen Substrat (2) und Metallformkörper (7) als stoffschlüssige oder kraftschlüssige Verbindung realisiert ist.

9. Verfahren zur Herstellung eines Leistungshalbleitermoduls mit folgenden Verfahrensschritten:
a) Bereitstellen eines Substrats (2) und eines Metallblechelements (9'), wobei das Metallblechelement (9') einen flachen ersten und einen flachen zweiten Anschlussbereich (19,20) aufweist und einen zwischen dem ersten und zweiten Anschlussbereich (19,20) angeordneten Verbindungsbereich (15') aufweist,
b) Stoffschlüssiges Verbinden des ersten Anschlussbereichs (19) mit dem Substrat (2), wobei das Metallblechelement (9') parallel zum Substrat (2) verläuft,
c) Abwickeln des nicht mit dem Substrat (2) verbunden Teils des Metallblechelements (9') weg vom Substrat (2),
d) Einschneiden des Metallblechelements (9') im Verbindungsbereich (15'), so dass alternierend angeordnete streifenförmige erste und zweite Formelemente (17,18) ausgebildet werden und gegensinniges Abwinkeln der ersten und zweiten Formelemente (17,18),
e) Verbinden eines elektrisch leitenden Laststromführungselements (10) mit dem zweiten Anschlussbereich (20) der Verbindungsvorrichtung (9).

10. Verfahren nach Anspruch 9, **dadurch gekennzeichnet, dass** das Einschneiden des Metallblechelements (9') im Verbindungsbereich (15'), so dass alternierend abgeordnete streifenförmige erste und zweite Formelemente (17,18) ausgebildet werden und das gegensinnige Abwinkeln der ersten und zweiten Formelemente, (17,18) mittels eines kombinierten Schneidbiegewerkzeugs (21), in einem gemeinsamen Arbeitsschritt erfolgen.

11. Verfahren nach einem der Ansprüche 9 oder 10, **dadurch gekennzeichnet, dass** das stoffschlüssige Verbinden des ersten Anschlussbereichs (19) mit dem Substrat (2) in einem gemeinsamen Arbeitsschritt mit einem stoffschlüssigen Verbinden von Leistungshalbleiterbauelementen (13) mit dem Substrat (2) und/oder in einem gemeinsamen Arbeitsschritt mit einem stoffschlüssigen Verbinden der den Leistungshalbleiterbauelementen (13) abgewandten Seite des Substrats (2) mit einem Metallformkörper (7) durchgeführt wird, wobei die jeweilige stoffschlüssige Verbindung in Form einer Sinterverbindung vorliegt.

12. Verfahren nach einem der Ansprüche 10 bis 11, **dadurch gekennzeichnet, dass** Verfahrensschritt d) vor Verfahrensschritt c) durchgeführt wird.

## Claims

1. Power semiconductor module having a substrate (2) and power semiconductor components (13) arranged on the substrate (2) and connected to the substrate (2), wherein the power semiconductor module (1) has an electrically conductive connecting device (9) formed in one piece, wherein the connecting device (9) has a flat first and a flat second connection region (19, 20) and an elastic region (15) arranged between the first and second connection regions (19, 20), wherein the elastic region (15) has strip-like first and second shaped elements (17, 18), which are angled over in opposite directions relative to each other and are arranged alternately, wherein the first connection region (19) is connected to the substrate (2), wherein the connecting device (9) connects the substrate (2) electrically conductively to an electrically conductive load-current-carrying element (10), wherein the second connection region (20) is connected to the load-current-carrying element (10).

2. Power semiconductor module according to Claim 1, **characterized in that** the current-carrying line cross section of the first connection region (19) and the current-carrying line cross section of the second connection region (20) differ in relation to the current-carrying line cross section of the elastic region (15) by a maximum of ±20% from the current-carrying line cross section of the elastic region (15).

3. Power semiconductor module according to one of the preceding claims, **characterized in that** the first connection region (19) has a section (19') which is connected to the substrate (2) and which extends parallel to the substrate (2).

4. Power semiconductor module according to one of the preceding claims, **characterized in that** at least part of the second connection region (20) extends away from the substrate (2).

5. Power semiconductor module according to one of the preceding claims, **characterized in that** the connection between the power semiconductor components (13) and the substrate (2), and/or between the first connection region (19) of the connecting device (9) and the substrate (2), is respectively implemented as an integral or force-fitting connection.

6. Power semiconductor module according to one of the preceding claims, **characterized in that**, on its side facing away from the power semiconductor components (13), the substrate (2) is connected to a shaped metal body (7).

7. Power semiconductor module according to Claim 6, **characterized in that** the shaped metal body (7) is formed as a metal plate, which is used for the thermal bonding of the substrate (2) to a heat sink or is formed as a heat sink.

8. Power semiconductor module according to Claim 6 or 7, **characterized in that** the connection between substrate (2) and shaped metal body (7) is implemented as an integral or force-fitting connection.

9. Method for manufacturing a power semiconductor module, having the following method steps:
a) providing a substrate (2) and a sheet metal element (9'), wherein the sheet metal element (9') has a flat first and a flat second connection region (19, 20) and a connecting region (15') arranged between the first and second connection region (19, 20),
b) connecting the first connection region (19) integrally to the substrate (2), the sheet metal element (9') extending parallel to the substrate (2),
c) unwinding the part of the sheet metal element (9') that is not connected to the substrate (2) away from the substrate (2),
d) cutting the sheet metal element (9') in the connecting region (15') such that alternately arranged strip-like first and second shaped elements (17, 18) are formed, and angling over the first and second shaped elements (17, 18) in opposite directions,
e) connecting an electrically conductive load-current-carrying element (10) to the second connection region (20) of the connecting device (9).

10. Method according to Claim 9, **characterized in that** the cutting of the sheet metal element (9') in the connecting region (15'), so that alternately arranged strip-like first and second shaped elements (17, 18) are formed, and angling over the first and second shaped elements (17, 18) in opposite directions by means of a combined cutting and bending tool (21), are carried out in a joint operation.

11. Method according to either of Claims 9 and 10, **characterized in that** the integral connection of the first connection region (19) to the substrate (2) is carried out in a joint operation with an integral connection of power semiconductor components (13) to the substrate (2) and/or in a joint operation with an integral connection of the side of the substrate (2) that faces away from the power semiconductor components (13) to a shaped metal body (7), wherein the respective integral connection is present in the form of a sintered connection.

12. Method according to either of Claims 10 or 11, **characterized in that** method step d) is carried out before method step c).

## Revendications

1. Module de semi-conducteur de puissance comprenant un substrat (2) et des composants semi-conducteurs de puissance (13) agencés sur le substrat (2) et reliés avec le substrat (2), le module de semi-conducteur de puissance (1) comprenant un dispositif de liaison électriquement conducteur (9) configuré d'un seul tenant, le dispositif de liaison (9) comprenant une première zone de raccordement plate et une deuxième zone de raccordement plate (19, 20), et une zone élastique (15) agencée entre la première et la deuxième zone de raccordement (19, 20), la zone élastique (15) comprenant des premiers et deuxièmes éléments de forme en forme de bande (17, 18), qui présentent un décalage angulaire en sens inverse l'un par rapport à l'autre et sont agencés en alternance, la première zone de raccordement (19) étant reliée avec le substrat (2), le dispositif de liaison (9) reliant le substrat (2) par une liaison électriquement conductrice avec un élément de conduction de courant de charge électriquement conducteur (10), la deuxième zone de raccordement (20) étant reliée avec l'élément de conduction de courant de charge (10).

2. Module de semi-conducteur de puissance selon la revendication 1, **caractérisé en ce que** la section transversale de conducteur conductrice de courant de la première zone de raccordement (19) et la section transversale de conducteur conductrice de courant de la deuxième zone de raccordement (20) diffèrent au regard de la section transversale de conducteur conductrice de courant de la zone élastique (15) d'au plus ± 20 % de la section transversale de conducteur conductrice de courant de la zone élastique (15).

3. Module de semi-conducteur de puissance selon l'une quelconque des revendications précédentes, **caractérisé en ce que** la première zone de raccordement (19) comprend une section (19') reliée avec le substrat (2), qui est parallèle au substrat (2).

4. Module de semi-conducteur de puissance selon l'une quelconque des revendications précédentes, **caractérisé en ce qu'**au moins une partie de la deuxième zone de raccordement (20) est à une distance du substrat (2).

5. Module de semi-conducteur de puissance selon l'une quelconque des revendications précédentes, **caractérisé en ce que** la liaison entre les composants semi-conducteurs de puissance (13) et le substrat (2), et/ou entre la première zone de raccordement (19) du dispositif de liaison (9) et le substrat (2), est à chaque fois réalisée sous la forme d'une liaison par coopération de matières ou par coopération de forces.

6. Module de semi-conducteur de puissance selon l'une quelconque des revendications précédentes, **caractérisé en ce que** le substrat (2) est relié sur son côté opposé aux composants semi-conducteurs de puissance (13) avec un corps moulé métallique (7).

7. Module de semi-conducteur de puissance selon la revendication 6, **caractérisé en ce que** le corps moulé métallique (7) est configuré sous la forme d'une plaque métallique, qui sert à la liaison thermique du substrat (2) sur un corps de refroidissement, ou sous la forme d'un corps de refroidissement.

8. Module de semi-conducteur de puissance selon la revendication 6 ou 7, **caractérisé en ce que** la liaison entre le substrat (2) et le corps moulé métallique (7) est réalisée sous la forme d'une liaison par coopération de matières ou par coopération de forces.

9. Procédé de fabrication d'un module de semi-conducteur de puissance comprenant les étapes de procédé suivantes :
a) la préparation d'un substrat (2) et d'un élément tôle métallique (9'), l'élément tôle métallique (9') comprenant une première zone de raccordement plate et une deuxième zone de raccordement plate (19, 20), et une zone de liaison (15') agencée entre la première et la deuxième zone de raccordement (19, 20),
b) la liaison par coopération de matières de la première zone de raccordement (19) avec le substrat (2), l'élément tôle métallique (9') étant parallèle au substrat (2),
c) le déroulement de la partie de l'élément tôle métallique (9') non reliée avec le substrat (2) à une distance du substrat (2),
d) la découpe de l'élément tôle métallique (9') dans la zone de liaison (15'), de telle sorte que des premiers et deuxièmes éléments de forme en forme de bande agencés en alternance (17, 18) soient formés, et le décalage angulaire en sens inverse des premiers et deuxièmes éléments de forme (17, 18),
e) la liaison d'un élément de conduction de courant de charge électriquement conducteur (10) avec la deuxième zone de raccordement (20) du dispositif de liaison (9).

10. Procédé selon la revendication 9, **caractérisé en ce que** la découpe de l'élément tôle métallique (9') dans la zone de liaison (15'), de telle sorte que des premiers et deuxièmes éléments de forme en forme de bande agencés en alternance (17, 18) soient formés, et le décalage angulaire en sens inverse des premiers et deuxièmes éléments de forme (17, 18) ont lieu dans une étape de travail commune, au moyen d'un outil de flexion et de découpe combiné (21).

11. Procédé selon l'une quelconque des revendications 9 ou 10, **caractérisé en ce que** la liaison par coopération de matières de la première zone de raccordement (19) avec le substrat (2) est réalisée dans une étape de travail commune avec une liaison par coopération de matières de composants semi-conducteurs de puissance (13) avec le substrat (2) et/ou dans une étape de travail commune avec une liaison par coopération de matières du côté du substrat (2) opposé aux composants semi-conducteurs de puissance (13) avec un corps moulé métallique (7), la liaison par coopération de matières respective se présentant sous la forme d'une liaison par frittage.

12. Procédé selon l'une quelconque des revendications 10 à 11, **caractérisé en ce que** l'étape de procédé d) est réalisée avant l'étape de procédé c).
